# EUROPEAN PATENT SPECIFICATION

(11) **EP 2 592 785 B1**
(45) Date of publication and mention of the grant of the patent: **18.02.2015**
(21) Application number: 11803798.5
(22) Date of filing: 06.07.2011
(51) Int. Cl.: H04L 12/28, H04M 11/06

(54) **APPARATUS FOR DIAGNOSING HOME APPLIANCES**
DIAGNOSEVORRICHTUNG FÜR HAUSHALTSGERÄTE
APPAREIL POUR LE DIAGNOSTIC D'APPAREILS MÉNAGERS

(30) Priority: 06.07.2010 US 361696 P; 06.07.2010 US 361667 P
(43) Date of publication of application: 15.05.2013
(73) Proprietor: LG Electronics Inc., Yeongdeungpo-gu Seoul 150-721 (KR)
(72) Inventor: KWON, Eui Hyeok, Changwon-si Kyungsangnam-do 641-110 (KR); KIM, Hyun Sang, Changwon-si Kyungsangnam-do 641-110 (KR)
(74) Representative: Greenaway, Martin William
(86) International application number: PCT/KR2011/004948
(87) International publication number: WO 2012/005512

(56) References cited:
- EP-A1- 0 510 519
- EP-A2- 0 887 989
- EP-A2- 1 186 695
- WO-A2-2009/134090
- KR-A- 20060 103 014
- KR-A- 20090 114 309
- KR-A- 20090 115 066
- KR-A- 20090 115 078
- US-A1- 2002 029 575
- SOZER E M: "Simulation and rapid prototyping environment for underwater acoustic communications: reconfigurable modem", OCEANS 2005 - EUROPE BREST, FRANCE 20-23 JUNE 2005, PISCATAWAY, NJ, USA,IEEE, US, vol. 1, 20 June 2005 (2005-06-20), pages 80-85, XP010838461, ISBN: 978-0-7803-9103-1

## Description

### [Technical Field]

The present invention relates to a home appliance diagnosing apparatus.

### [Background Art]

When an error occurs to an operating home appliance, a user sends an inquiry to a customer service center and takes care of it on his/her own or requests them to send a service person who may takes proper steps.

However, the above measures taken on the erroneous operation of the home appliance fail to allow the user to correctly let them know about the malfunction or to get the problem to be properly responded.

Recently, there has been a home appliance diagnosis system that may output an erroneous symptom of a home appliance in the form of a predetermined pattern of sound and may transfer the sound through a phone to the service center for the symptom to be transmitted more correctly to the service center.

Such diagnosis system includes a diagnosis apparatus that analyzes a signal sound transmitted from the home appliance and thereby performs a diagnosis. A resident operator in the service center manipulates the diagnosis apparatus to perform a diagnosis.

### [Disclosure]

### [Technical Problem]

An object of the present invention is to provide a home appliance diagnosis apparatus that displays diagnosis processes and diagnosis results of a home appliance so that the processes and results may be known to an operator.

Another object of the present invention is to provide a home appliance diagnosis apparatus that displays product information of a home appliance, with the information classified.

### [Technical Solution]

According to the present invention, there is provided a home appliance diagnosis apparatus receiving a sound signal including product information from a home appliance through a communication network, extracting the product information from the sound signal, and performing diagnosis on the home appliance based on the extracted product information, the home appliance diagnosis apparatus including a sound recording unit that records the sound signal including the product information received from the home appliance, a signal processing unit that extracts the product information from the sound signal recorded by the sound recording unit, a diagnosing unit that performs a diagnosis on the home appliance based on the product information extracted by the signal processing unit, and a displaying unit that provides a user interface interacting with the sound recording unit, the signal processing unit, and the diagnosing unit.

### [Advantageous Effects]

According to the present invention, a home appliance diagnosis apparatus may display diagnosis results of a home appliance so that an operator may recognize the diagnosis results of the home appliance.

Further, according to the present invention, the home appliance diagnosis apparatus allows an operator to immediately grasp diagnosis results of a home appliance, so that a response may be quickly made to a user by the operator.

Further, according to the present invention, the home appliance diagnosis apparatus may classify and display diagnosis results of a home appliance so that an operator may clearly grasp diagnosis results.

Further, according to the present invention, the home appliance diagnosis apparatus displays measures necessary to be taken according to diagnosis results. Accordingly, an operator may identify the measures displayed on the diagnosis apparatus and may let a user or repair person know the measures, thus facilitating management after sale of the home appliance.

### [Description of Drawings]

Fig. 1 illustrates a home appliance diagnosis system.
Fig. 2 illustrates examples where product information is transformed into frequency signals through the home appliance shown in Fig. 1.
Fig. 3 illustrates main components of a home appliance diagnosis apparatus according to an embodiment of the present invention.
Fig. 4 illustrates an example of a UI (User Interface) displayed through the displaying unit of Fig. 3.

### [Best Mode]

Advantages and features of the present invention and methods for achieving the advantages and features may become apparent from the embodiments to be hereinafter described in conjunction with the drawings. However, the present invention is not limited to the embodiments and may be embodied in various modifications. The embodiments are provided merely to fully disclose the present invention and advise those skilled in the art of the category of the invention. The present invention is defined only by the appending claims. The same reference numbers denote the same elements throughout the specification.

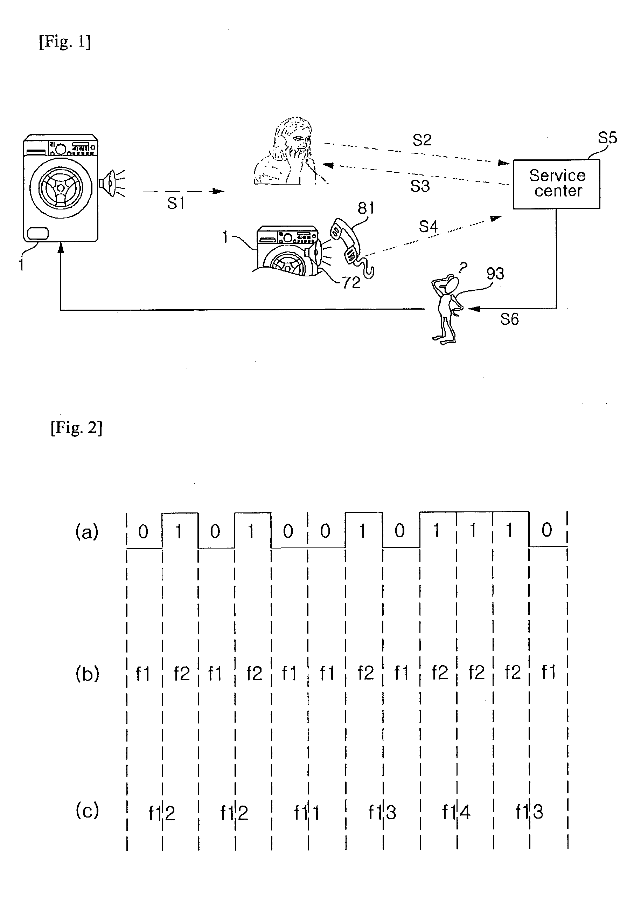

Fig. 1 illustrates a home appliance diagnosis system. Fig. 2 illustrates examples where product information is transformed into frequency signals through the home appliance of Fig. 1.

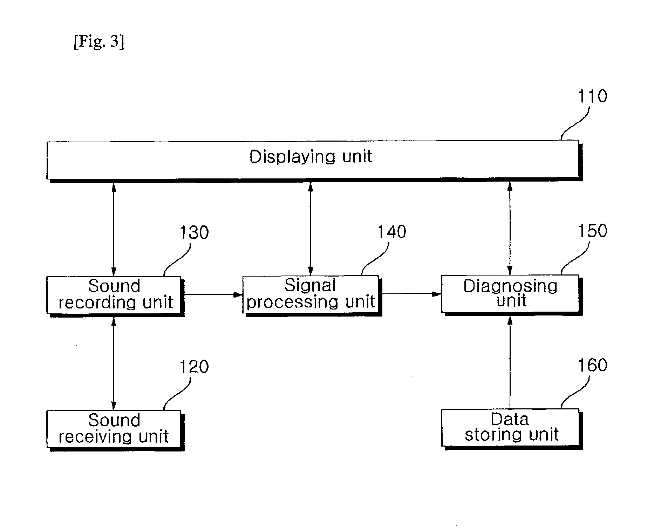

Referring to Fig. 1, the home appliance diagnosis system includes a home appliance 1 that outputs a sound signal including product information and a diagnosis apparatus (100, refer to Fig. 3) that receives the sound signal output from the home appliance through a communication network and analyzes the sound signal to thereby diagnose the home appliance.

Fig. 1 illustrates the washing machine 1 as an example of the home appliance, but is not limited thereto. It should be noted that the diagnosis system or diagnosis apparatus to be described below may also be applicable to various types of home appliances, such as a washing machine, refrigerator, air conditioner, dish washer, or TV.

The home appliance 1 transforms product information into a predetermined sound signal and outputs the sound signal. The product information may include at least one of operation information, use information, and failure information of the home appliance 1.

The operation information may include setting information set by use and information on an operation state of the home appliance. When a washing machine is taken as an example, the operation information may include cold/hot water settings upon washing or rinsing, setting values depending on the degree of contamination of laundry, setting values of rotation speed of the drum, reserved setting times, etc.

The use information may include identification information through which the type of the home appliance may be identified and information on an operation history of the home appliance. The operation history information may include information on the pattern in which the washing machine has been operated in the past several hours or information on the operation pattern of the washing machine in the past several cycles.

The failure information may include information on an erroneous operation or malfunction of the home appliance. The failure information may be, e.g., an error code, which indicates whether various components of the home appliance normally operate or indicates that an erroneous operation of the home appliance comes from the user's mal-operation.

To output the sound signal including the product information, the home appliance 1 may include a sound output unit that may include a sound output means, such as a speaker or a buzzer. In such case, the sound output unit outputs the product information as a signal sound having a predetermined frequency pattern and the signal sound is received by a terminal 81 via air.

However, the sound signal output through the sound output unit is not necessarily transferred via air. For example, the sound output unit may be directly connected to an input terminal of the terminal, and in this case, the sound signal output through the sound output unit is directly input to the terminal as an electrical signal having a frequency characteristic.

As another example, communication may be done between the home appliance and the terminal through a communication network based on wireless LAN, such as WI-FI (Wireless-Fidelity), and in this case, the sound signal including the product information output through the sound output unit is received by the terminal through wireless communication.

Another example is a case where the home appliance is wiredly/wirelessly connected directly to the communication network without the need of the terminal. In such case, the home appliance may include a network access device that interfaces between the sound output unit and the communication network.

Referring to Fig. 1, a process of performing diagnosis by the home appliance 1 is as follows.

In case an error occurs to the home appliance 1 or the home appliance 1 does not normally operate due to an environment where the home appliance 1 is installed or a user's mal-operation, a predetermined alert sound is output from the home appliance 1 (S1). A user recognizes the alert sound and takes a proper measure, and as necessary, sends an inquiry to a service center (S2). The user explains the erroneous symptoms of the home appliance 1 to an operator, and the operator informs the user of a corresponding measure (S3). The user may attempt to manipulate the home appliance 1 according to the measure informed by the operator, but such measure may be not enough to address the erroneous symptoms of the home appliance 1. The reason of such case may be because the user fails to correctly explain the condition of the home appliance 1 to the operator or it is impossible to precisely diagnose the cause of the malfunction of the home appliance 1 with the erroneous symptoms explained by the user.

In case the operator's advices are not enough to properly address the erroneous symptoms of the home appliance 1, the user brings his phone close to the sound output unit 72 following the operator's guide and manipulates the home appliance 1 so that the home appliance 1 performs a diagnosis mode. The home appliance 1 may include a selection unit that allows the user to select execution of the diagnosis mode, and the selection unit may consist of a button, a dial, a tact switch, and a touch pad.

If the home appliance 1 enters into the diagnosis mode by the user's manipulating the selection unit, the home appliance 1 transforms the product information into a predetermined signal sound and outputs the signal sound. Hereinafter, the sound signal output through the sound output unit 72 is transmitted to the terminal 81 via air, but is not limited thereto, and various embodiments may be possible as described above.

The terminal 81 receives the signal sound output from the home appliance 1. The terminal 81 is connected to a communication network and transmits the sound signal including the product information to the service center (S4).

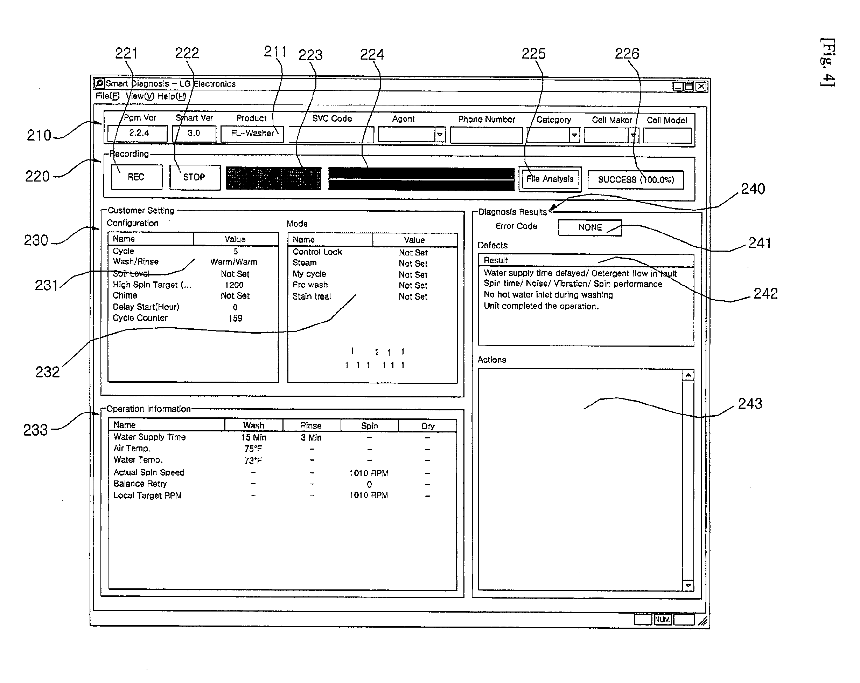

The service center has a diagnosis apparatus (100, refer to Fig. 3) that analyzes the sound signal transmitted through the communication network and performs a diagnosis on the home appliance. The diagnosis apparatus 100 inversely extracts the product information from the sound signal received through the communication network and analyzes the product information to thereby diagnose the home appliance 1. The process of diagnosing the home appliance which is performed through the diagnosis apparatus 100 will be described below in more detail with reference to Figs. 3 and 4.

Meanwhile, a diagnosis result may be provided to a repair person 93 who is to be dispatched to the user's home for fixing the home appliance 1 (S6). The repair person 93 verifies the diagnosis result provided through, e.g., a terminal, and visits the user with parts necessary to repair the home appliance 1. Since the necessary parts may be prepared in advance, the repair person 93 has a considerably low chance of revisiting the user due to insufficient preparation.

Referring to Fig. 2, the signal sound (or sound signal) output from the home appliance 1 includes a pattern of a combination of a plurality of frequencies different from each other. The frequency signals obtained by classifying the signal sound with the pattern of the combination of the plurality of frequencies depending on a predetermined criterion correspond to symbols, respectively, which constitute the product information.

For example, Fig. 2(a) illustrates a digital signal obtained by configuring the product information with a combination of 0's and 1's, and Fig. 2(b) illustrates an output signal sound consisting of a combination of f1's and f2's that are different frequencies from each other. f1 corresponds to data 0, and f2 corresponds to data 1, and the length of the frequency signal corresponding to each symbol is the same.

Meanwhile, Fig. 2(c) illustrates, as another example of transforming the product information into frequency signals, that the digital signals of Fig. 2(a) are transformed into a combination of four different frequencies consisting of f11, f12, f13, and f14. Here, f11 corresponds to symbol '00', f12 to symbol '01', f13 to symbol '10', and f14 to symbol '11', and the length of the frequency signal corresponding to each symbol is the same.

Fig. 3 illustrates main components of a home appliance diagnosis apparatus according to an embodiment of the present invention. Referring to Fig. 3, the diagnosis apparatus 100 may include a displaying unit 110, a receiving unit 120, a sound recording unit 130, a signal processing unit 140, a diagnosing unit 150, and/or a data storing unit 160.

The displaying unit 110 displays various information including diagnosis progressing situations and/or diagnosis results so that an operator may recognize the information.

The receiving unit 120 receives a sound signal through a communication network. As described above in connection with Fig. 1, a sound signal including product information generated from the home appliance 1 is transmitted through the terminal 81 and a communication network connected to the terminal 81 to the receiving unit 120.

The sound recording unit 130 records the sound signal received through the receiving unit 120. The sound recording unit 130 may record the sound signal received through the receiving unit 120 in the wave file format. The diagnosis apparatus 100 may include a recording medium, such as a RAM, a hard disk, a CD-ROM, a NAND flash memory, or an EDORAM, so as to record the signal sound file.

The signal processing unit 140 inversely extracts the product information from the sound signal recorded by the sound recording unit 130. The signal processing unit 140 inversely extracts the product information from the sound signal through demodulation and decoding processes.

The diagnosing unit 150 analyzes the product information extracted by the signal processing unit 140 to thereby perform a diagnosis on the home appliance 1. The diagnosing unit 150 analyzes the product information and diagnoses the home appliance in association with the data storing unit 160. The data storing unit 160 may store diagnosis logics classified depending on the type of the home appliance and diagnosed data items.

The diagnosis logics and the diagnosed data items may be stored in tables, respectively. When the table for storing the diagnosis logics is referred to as a logic table, and the table for storing the diagnosed data items is referred to as a data table, the two tables are managed separately for each home appliance. Accordingly, in case there is a small change, such as when a diagnosis logic is added to the existing system, an item can be added to the logic table, but in case a new home appliance to be subjected to diagnosis is added, diagnosis data is added, or the diagnosis logics are completely changed, a new table may be generated.

The diagnosing unit 150 calls a diagnosis logic from the data storing unit 160 and performs a diagnosis based on the product information generated by the signal processing unit 140. The diagnosing unit 150 calls the logics for determining any fault from the logic table in a one-by-one manner, compares the product information with the diagnosis data depending on the logics, and after the comparison is done, outputs the final result through the displaying unit 110.

Fig. 4 illustrates an example of a UI (User Interface) displayed through the displaying unit of Fig. 3. Referring to Fig. 4, the user interface displayed through the displaying unit 110 of the diagnosis apparatus may include at least one of a product identification information displaying area 210, a diagnosis progressing situation displaying area 220, a user setting displaying area 230, and a diagnosis result displaying area 240.

The type of a home appliance to be diagnosed may be displayed on the product identification information displaying area 210. The type of the product to be diagnosed, which is grasped from the identification information included in the product information extracted by the signal processing unit 140, is displayed on the product identification information displaying area 210. In this embodiment, the home appliance to be diagnosed is, as an example, a front loading-type washing machine 211.

The diagnosis progressing situation displaying area 220 may include at least one of a recording start selecting area 221, a recording stop selecting area 222, a recording progressing situation displaying area 223, a waveform displaying area 223, a diagnosis start selecting area 225, and diagnosis success rate displaying area 226.

The recording start selecting area 221 is selected by an operator, who identifies a predetermined start signal indicating that the product information starts to be output as a signal sound, while a call with a user is established and selects the recording start selecting area 221. If the recording start selecting area 221 is selected, the sound recording unit 130 starts recording the sound signal received through the receiving unit 120.

If the recording stop selecting area 222 is selected, the recording now in progress is stopped. The recording that is currently conducted through the sound recording unit 130 is stopped.

The recording progressing situation displaying area 223 displays a recording progressing situation of the sound recording unit 130. In this embodiment, as an example, a bar is shown with a length changing depending on the recording progressing situation.

The waveform displaying area 224 displays the waveform of the sound signal as an image corresponding to the recording progressing situation of the receiving unit 120. Through this, the operator may recognize whether the sound signal being currently recorded suffers from a loss or distortion, and when determining that serious sound signal losses or distortions occur and so re-recording is required, the operator may take measures, such as re-receiving/re-recording, through the recording stop selecting area 222 and the recording start selecting area 221.

If the diagnosis start selecting area 225 is selected, the home appliance starts to be diagnosed based on the sound signal recorded by the sound recording unit 130. At this time, the signal processing unit 140 inversely extracts the product information from the sound signal recorded by the sound recording unit 130, and the diagnosing unit 150 performs a diagnosis on the home appliance based on the product information extracted by the signal processing unit 140.

The diagnosis success rate displaying area 226 displays a success rate of the home appliance diagnosis process performed by the diagnosing unit 150.

The user setting displaying area 230 displays at least one of operation information and setting information included in the product information extracted through the signal processing unit 140.

More specifically, the user setting displaying area 230 may include at least one of a setting information displaying area 231 that displays the setting information, a mode setting displaying area 232 that displays whether to set various operation modes provided from the home appliance to be home appliance, and an operation information displaying area 233 that displays the operation information.

The diagnosis result displaying area 240 may include at least one of an error code displaying area 241, a cause analysis displaying area 242, and a measure displaying area 243.

When an error code is included in the product information extracted through the signal processing unit 140, this is displayed on the error code displaying area 241. The error code classifies erroneous operations of the home appliance depending on each symptom and this is grasped by the home appliance itself.

The cause analysis displaying area 242 displays causes of the erroneous symptoms of the home appliance which are analyzed as the diagnosis result by the diagnosing unit 150. The diagnosing unit 150 calls, one by one, the logics for determining any fault of the home appliance from the logic table of the data storing unit 160, compares the product information with the diagnosis data according to the logics, and analyzes and outputs causes of the erroneous operations of the home appliance.

The measure displaying area 243 may display a measure for responding to the fault of the home appliance. The operator may identify the measure displaying area 23 and may provide a user with a measure to be taken or a repair person with a responding measure.

Although the exemplary embodiments of the present invention have been described, it is understood that the present invention should not be limited to these exemplary embodiments but various changes and modifications can be made by one ordinary skilled in the art within scope of the present invention as hereinafter claimed.

## Claims

1. A home appliance diagnosis apparatus for receiving a sound signal including product information from a home appliance through a communication network, extracting the product information from the sound signal, and performing diagnosis on the home appliance based on the extracted product information, the home appliance diagnosis apparatus comprising:
a sound recording unit (130) arranged to record the sound signal including the product information received from the home appliance;
a signal processing unit (140) arranged to extract the product information from the sound signal recorded by the sound recording unit;
a diagnosing unit (150) arranged to perform a diagnosis on the home appliance based on the product information extracted by the signal processing unit; and
a displaying unit (110) arranged to provide a user interface interacting with the sound recording unit, the signal processing unit, and the diagnosing unit, wherein the user interface further includes a diagnosis start selecting area (221), and wherein if the diagnosis start selecting area is selected, the product information is extracted by the signal processing unit, and the diagnosing unit performs a diagnosis on the home appliance based on the extracted product information
wherein the user interface includes a waveform displaying area (223) arranged to display a waveform of the sound signal including the product information that is in progress with recording by the sound recording unit.

2. The home appliance diagnosis apparatus of claim 1, wherein the user interface further includes a diagnosis success rate displaying area arranged to display a success rate of a process of performing diagnosis by the diagnosing unit.

3. The home appliance diagnosis apparatus of claim 1, wherein the user interface includes a diagnosis result displaying area arranged to display a diagnosis result of the diagnosing unit.

4. The home appliance diagnosis apparatus of claim 3, wherein the diagnosis result displaying area includes a measure displaying area arranged to display a measure to be taken based on the diagnosis result of the diagnosing unit.

5. The home appliance diagnosis apparatus of claim 1, wherein the user interface includes at least one of a setting information displaying area arranged to display setting information included in the product information extracted by the signal processing unit, an operation information displaying area arranged to display operation information included in the product information extracted by the signal processing unit, and an error code displaying area arranged to display an error code included in the product information extracted by the signal processing unit.

6. The home appliance diagnosis apparatus of claim 1, further comprising a data storing unit arranged to store diagnosis logics classified depending on the type of the home appliance and diagnosed data items, and wherein the diagnosing unit is arranged to produce a diagnosis result by comparing the product information extracted by the signal processing unit with the diagnosed data items according to the diagnosis logics of the data storing unit.

7. The home appliance diagnosis apparatus of claim 1, wherein the user interface includes a recording start selecting area, and wherein the sound recording unit is arranged to record the sound signal including the product information according to selection of the recording start selecting area.

8. The home appliance diagnosis apparatus of claim 1, wherein the user interface includes a recording stop selecting area arranged to select to stop recording in progress by the sound recording unit.

9. The home appliance diagnosis apparatus of claim 1, wherein the user interface includes a recording progressing situation displaying area arranged to display a recording progressing situation of the sound signal including the product information by the sound recording unit.

## Patentansprüche

1. Haushaltsgerät-Diagnosevorrichtung zum Empfangen eines Tonsignals, das Produktinformationen enthält, von einem Haushaltsgerät durch ein Kommunikationsnetzwerk, Extrahieren der Produktinformationen aus dem Tonsignal und Durchführen von Diagnose für das Haushaltsgerät auf der Grundlage der extrahierten Produktinformationen, wobei die Haushaltsgerät-Diagnosevorrichtung aufweist:
eine Tonaufzeichnungseinheit (130), die dazu ausgelegt ist, das Tonsignal, das die von dem Haushaltsgerät empfangenen Produktinformationen enthält, aufzuzeichnen;
eine Signalverarbeitungseinheit (140), die dazu ausgelegt ist, die Produktinformationen aus dem von der Tonaufzeichnungseinheit aufgezeichneten Tonsignal zu extrahieren;
eine Diagnoseeinheit (150), die dazu ausgelegt ist, eine Diagnose für das Haushaltsgerät auf der Grundlage der von der Signalverarbeitungseinheit extrahierten Produktinformationen durchzuführen; und
eine Anzeigeeinheit (110), die dazu ausgelegt ist, eine Benutzerschnittstelle bereitzustellen, die mit der Tonaufzeichnungseinheit, der Signalverarbeitungseinheit und der Diagnoseeinheit zusammenwirkt, wobei die Benutzerschnittstelle des Weiteren einen Diagnosestartauswahlbereich (221) aufweist, und wobei, wenn der Diagnosestartauswahlbereich ausgewählt wird, die Produktinformationen durch die Signalverarbeitungseinheit extrahiert werden und die Diagnoseeinheit eine Diagnose für das Haushaltsgerät auf der Grundlage der extrahierten Produktinformationen durchführt,
wobei die Benutzerschnittstelle einen Wellenformanzeigebereich (223) aufweist, der dazu ausgelegt ist, eine Wellenform des Tonsignals, das die Produktinformationen enthält und das gerade von der Tonaufzeichnungseinheit aufgezeichnet wird, anzuzeigen.

2. Haushaltsgerät-Diagnosevorrichtung nach Anspruch 1, wobei die Benutzerschnittstelle des Weiteren einen Diagnoseerfolgsraten-Anzeigebereich aufweist, der dazu ausgelegt ist, eine Erfolgsrate eines Vorgangs des Durchführens einer Diagnose durch die Diagnoseeinheit anzuzeigen.

3. Haushaltsgerät-Diagnosevorrichtung nach Anspruch 1, wobei die Benutzerschnittstelle einen Diagnoseergebnis-Anzeigebereich aufweist, der dazu ausgelegt ist, ein Diagnoseergebnis der Diagnoseeinheit anzuzeigen.

4. Haushaltsgerät-Diagnosevorrichtung nach Anspruch 3, wobei der Diagnoseergebnis-Anzeigebereich einen Maßnahmen-Anzeigebereich aufweist, der dazu ausgelegt ist, eine auf der Grundlage des Diagnoseergebnisses der Diagnoseeinheit zu treffende Maßnahme anzuzeigen.

5. Haushaltsgerät-Diagnosevorrichtung nach Anspruch 1, wobei die Benutzerschnittstelle wenigstens eines aufweist eines Einstellinformationen-Anzeigebereichs, der dazu ausgelegt ist, Einstellinformationen anzuzeigen, die in den von der Signalverarbeitungseinheit extrahierten Produktinformationen enthalten sind, eines Betriebsinformationen-Anzeigebereichs, der dazu ausgelegt ist, Betriebsinformationen anzuzeigen, die in den von der Signalverarbeitungseinheit extrahierten Produktinformationen enthalten sind, und eines Fehlercode-Anzeigebereichs, der dazu ausgelegt ist, einen Fehlercode anzuzeigen, der in den von der Signalverarbeitungseinheit extrahierten Produktinformationen enthalten ist.

6. Haushaltsgerät-Diagnosevorrichtung nach Anspruch 1, die des Weiteren eine Datenspeichereinheit aufweist, die dazu ausgelegt ist, Diagnoselogik zu speichern, die abhängig vom Typ des Haushaltsgeräts und der diagnostizierten Datenelemente klassifiziert wird, und wobei die Diagnoseeinheit dazu ausgelegt ist, ein Diagnoseergebnis durch Vergleichen der von der Signalverarbeitungseinheit extrahierten Produktinformationen mit den diagnostizierten Datenelementen gemäß der Diagnoselogik der Datenspeichereinheit zu erzeugen.

7. Haushaltsgerät-Diagnosevorrichtung nach Anspruch 1, wobei die Benutzerschnittstelle einen Aufzeichnungsbeginn-Auswahlbereich aufweist, und wobei die Tonaufzeichnungseinheit dazu ausgelegt ist, das Tonsignal, das die Produktinformationen enthält, gemäß der Auswahl des Aufzeichnungsbeginn-Auswahlbereichs aufzuzeichnen.

8. Haushaltsgerät-Diagnosevorrichtung nach Anspruch 1, wobei die Benutzerschnittstelle einen Aufzeichnungsstopp-Auswahlbereich aufweist, der dazu ausgelegt ist auszuwählen, dass das Aufzeichnen, das gerade von der Tonaufzeichnungseinheit durchgeführt wird, gestoppt wird.

9. Haushaltsgerät-Diagnosevorrichtung nach Anspruch 1, wobei die Benutzerschnittstelle einen Anzeigebereich für eine Aufzeichnungsdurchführungssituation aufweist, der dazu ausgelegt ist, eine Aufzeichnungsdurchführungssituation des Tonsignals, das die Produktinformationen enthält, durch die Tonaufzeichnungseinheit anzuzeigen.

## Revendications

1. Dispositif de diagnostic d'appareil ménager pour recevoir un signal sonore incluant des informations de produit en provenance d'un appareil ménager par l'intermédiaire d'un réseau de communication, extraire les informations de produit à partir du signal sonore, et exécuter un diagnostic sur l'appareil ménager en se basant sur les informations de produit extraites, le dispositif de diagnostic d'appareil ménager comprenant :
une unité d'enregistrement de son (130) agencée pour enregistrer le signal sonore incluant les informations de produit reçues en provenance de l'appareil ménager ;
une unité de traitement de signal (140) agencée pour extraire les informations de produit à partir du signal sonore enregistré par l'unité d'enregistrement de son ;
une unité de diagnostic (150) agencée pour effectuer un diagnostic sur l'appareil ménager en se basant sur les informations de produit extraites par l'unité de traitement de signal ; et
une unité d'affichage (110) agencée pour fournir une interface utilisateur interagissant avec l'unité d'enregistrement de son, l'unité de traitement de signal et l'unité de diagnostic, dans laquelle l'interface utilisateur inclut en outre une zone de sélection de début de diagnostic (221), et dans laquelle si la zone de sélection de début de diagnostic est sélectionnée, les informations de produit sont extraites par l'unité de traitement de signal, et l'unité de diagnostic effectue un diagnostic sur l'appareil ménager en se basant sur les informations de produit extraites
dans lequel l'interface utilisateur inclut une zone d'affichage de forme d'onde (223) agencée pour afficher une forme d'onde du signal sonore incluant les informations de produit qui sont en cours d'enregistrement par l'unité d'enregistrement de son.

2. Dispositif de diagnostic d'appareil ménager selon la revendication 1, dans lequel l'interface utilisateur inclut en outre une zone d'affichage de taux de succès de diagnostic agencée pour afficher un taux de succès d'un processus de réalisation de diagnostic par l'unité de diagnostic.

3. Dispositif de diagnostic d'appareil ménager selon la revendication 1, dans lequel l'interface utilisateur inclut une zone d'affichage de résultat de diagnostic agencée pour afficher un résultat de diagnostic de l'unité de diagnostic.

4. Dispositif de diagnostic d'appareil ménager selon la revendication 3, dans lequel la zone d'affichage de résultat de diagnostic inclut une zone d'affichage de mesure agencée pour afficher une mesure à prendre en se basant sur le résultat de diagnostic de l'unité de diagnostic.

5. Dispositif de diagnostic d'appareil ménager selon la revendication 1, dans lequel l'interface utilisateur inclut au moins une d'une zone d'affichage d'informations de réglage agencée pour afficher des informations de réglage incluses dans les informations de produit extraites par l'unité de traitement de signal, une zone d'affichage d'informations de mise en oeuvre agencée pour afficher des informations de mise en oeuvre incluses dans les informations de produit extraites par l'unité de traitement de signal, et une zone d'affichage de code d'erreur agencée pour afficher un code d'erreur inclus dans les informations de produit extraites par l'unité de traitement de signal.

6. Dispositif de diagnostic d'appareil ménager selon la revendication 1, comprenant en outre une unité de stockage de données agencée pour stocker des logiques de diagnostic classées en fonction du type de l'appareil ménager et des éléments de données diagnostiqués, et dans lequel l'unité de diagnostic est agencée pour produire un résultat de diagnostic en comparant les informations de produit extraites par l'unité de traitement de signal avec les éléments de données diagnostiqués selon les logiques de diagnostic de l'unité de stockage de données.

7. Dispositif de diagnostic d'appareil ménager selon la revendication 1, dans lequel l'interface utilisateur inclut une zone de sélection de début d'enregistrement, et dans lequel l'unité d'enregistrement de son est agencée pour enregistrer le signal sonore incluant les informations de produit selon une sélection de la zone de sélection de début d'enregistrement.

8. Dispositif de diagnostic d'appareil ménager selon la revendication 1, dans lequel l'interface utilisateur inclut une zone de sélection d'arrêt d'enregistrement agencée pour sélectionner d'arrêter l'enregistrement en cours par l'unité d'enregistrement de son.

9. Dispositif de diagnostic d'appareil ménager selon la revendication 1, dans lequel l'interface utilisateur inclut une zone d'affichage de situation de progression d'enregistrement agencée pour afficher une situation de progression d'enregistrement du signal sonore incluant les informations de produit par l'unité d'enregistrement de son.
